# EUROPEAN PATENT APPLICATION

(11) **EP 4 656 767 A1**
(43) Date of publication of application: **03.12.2025**
(21) Application number: 25170356.7
(22) Date of filing: 14.04.2025
(51) Int. Cl.: C23C 14/12, C23C 14/24, C23C 14/56, C23C 14/22, C23C 14/04, C23C 14/02

(54) **APPARATUS AND METHOD FOR MANUFACTURING DISPLAY DEVICE**

(30) Priority: 02.05.2024 KR 20240058672
(71) Applicant: Samsung Display Co., Ltd., Yongin-si, Gyeonggi-do 17113 (KR)
(72) Inventor: Han, Jongseok, 17113 Giheung-gu, Yongin-si, Gyeonggi-do (KR); Kim, Dalho, 17113 Giheung-gu, Yongin-si, Gyeonggi-do (KR); Kim, Jiyoung, 17113 Giheung-gu, Yongin-si, Gyeonggi-do (KR); Kim, Jihye, 17113 Giheung-gu, Yongin-si, Gyeonggi-do (KR); Park, Eunji, 17113 Giheung-gu, Yongin-si, Gyeonggi-do (KR); Sung, Hyangki, 17113 Giheung-gu, Yongin-si, Gyeonggi-do (KR)
(74) Representative: Dr. Weitzel & Partner

(57) **Abstract**

An apparatus for manufacturing a display device which deposits on a display substrate arranged in a virtual plane a first deposition material and a second deposition material. The apparatus may include a deposition source with multiple deposition parts that include differing deposition materials onto different areas or portions of the virtual plane. The deposition source moves with respect to the display substrate so that the deposition materials may be deposited onto the display substrate in case that at least one of the different areas of the virtual plane coincide with a location of the display substate.

## Description

The present invention relates to an apparatus for manufacturing a display device and a method of manufacturing a display device.

### Description of the Related Art

Electronic devices based on mobility are widely used. Recently, tablet personal computers (PCs), in addition to small-sized electronic devices such as mobile phones, have been widely used as mobile electronic devices.

To support various functions, such mobile electronic devices include display devices to provide visual information, such as an image or a video, to a user. Recently, with the miniaturization of components for driving the display devices, proportions of the display devices occupying the electronic devices are gradually increasing, and the display devices having structures that are bendable from approximately flat states to have certain angles are also being developed.

### SUMMARY

One or more embodiments include an apparatus for manufacturing a display device, in which a manufacturing time and manufacturing costs of the display device may be reduced and a material piling up phenomenon is reduced. The invention is defined by the features of the independent claims. The dependent claims describe preferred embodiments.

Additional aspects will be set forth in part in the description which follows and, in part, will be apparent from the description, or may be learned by practice of the presented embodiments of the invention.

According to one or more embodiments, an apparatus for manufacturing a display device may include a chamber, a support part within the chamber supporting a display substrate, a deposition source arranged in the chamber and including a first deposition part that ejects a first deposition material towards the display substrate, and a second deposition part that ejects a second deposition material towards the display substrate, and a moving part that moves the deposition source in a first direction and a second direction opposite to the first direction relative to the display substrate, wherein the display substrate is arranged on a virtual plane, the virtual plane includes a first area where the first deposition material reaches and which is spaced apart from the second deposition material, a second area where the first deposition material and the second deposition material each reach, and a third area where the second deposition material reaches and spaced apart from the first deposition material, and the first area, the second area, and the third area are defined with respect to the deposition source and move together with the deposition source to different locations on the virtual plane.

The invention also provides a method of manufacturing a display device, wherein the support part within the chamber of the mentioned apparatus supports the display substrate, the first deposition part of the deposition source ejects the first deposition material towards the display substrate, the second deposition part of the deposition source ejects the second deposition material towards the display substrate, and the moving part moves the deposition source in the first direction and the second direction opposite to the first direction relative to the display substrate, wherein the display substrate is arranged on a virtual plane, the virtual plane includes the first area where the first deposition material reaches and which is spaced apart from the second deposition material, the second area where the first deposition material and the second deposition material each reach, and the third area where the second deposition material reaches and which is spaced apart from the first deposition material, and the first area, the second area, and the third area are defined with respect to the deposition source and move together with the deposition source to different locations on the virtual plane.

In case that the deposition source moves sequentially in the first direction and the second direction relative to the display substrate, the display substrate may sequentially pass through the first area, the second area, the third area, the second area, and the first area.

In case that the display substrate passes through the first area, a first layer including the first deposition material may be deposited on the display substrate, in case that the display substrate passes through the second area, a second layer including the first deposition material and the second deposition material may be deposited on the display substrate, in case that the display substrate passes through the third area, a third layer including the second deposition material may be deposited on the display substrate, in case that the display substrate passes through the second area again, a fourth layer including the first deposition material and the second deposition material may be deposited on the display substrate, and in case that the display substrate passes through the first area again, a fifth layer including the first deposition material may be deposited on the display substrate.

In the second layer, a concentration of the second deposition material may gradually increase compared to the first deposition material in a direction towards the third layer.

In the fourth layer, a concentration of the first deposition material may gradually increase compared to the second deposition material in a direction towards the fifth layer.

Each of the first deposition material and the second deposition material may include a capping material.

A refractive index of the third layer may be greater than a refractive index of each of the first layer and the fifth layer.

A thickness of the fifth layer may be greater than a thickness of the first layer.

The first deposition part may include a first-1 deposition part and a first-2 deposition part which eject a same material.

The first-1 deposition part, the first-2 deposition part, and the second deposition part may be sequentially arranged in a linear manner.

According to one or more embodiments, an apparatus for manufacturing a display device may include a chamber, a deposition source arranged in the chamber and including a first deposition part that ejects a first deposition material towards a display substrate and a second deposition part that ejects a second deposition material towards the display substrate, and a moving part that sequentially moves the deposition source in a first direction and a second direction opposite to the first direction relative to the display substrate, wherein a first layer including the first deposition material, a second layer including the first deposition material and the second deposition material, a third layer including the second deposition material, a fourth layer including the first deposition material and the second deposition material, and a fifth layer including the first deposition material may be sequentially deposited on the display substrate, wherein the display substrate may be disposed in a virtual plane defined with respect to the deposition source.

In the second layer, a concentration of the second deposition material may gradually increase compared to the first deposition material in a direction towards the third layer.

In the fourth layer, a concentration of the first deposition material may gradually increase compared to the second deposition material in a direction towards the fifth layer.

Each of the first deposition material and the second deposition material may include a capping material.

A refractive index of the third layer may be greater than a refractive index of each of the first layer and the fifth layer.

A thickness of the fifth layer may be greater than a thickness of the first layer.

The virtual plane may include a first area where the first deposition material reaches and spaced apart from the second deposition material, a second area where the first deposition material and the second deposition material each reach, and a third area where the second deposition material reaches and spaced apart from the first deposition material.

The display substrate may sequentially pass through the first area, the second area, the third area, the second area, and the first area.

The first deposition part may include a first-1 deposition part and a first-2 deposition part which eject a same material.

The first-1 deposition part, the first-2 deposition part, and the second deposition part may be sequentially arranged in a linear manner.

Other aspects, features, and advantages may become clear from the following drawings, the claims, and the detailed description of the invention.

### BRIEF DESCRIPTION OF THE DRAWINGS

The above and other aspects, features, and advantages of certain embodiments of the invention will be more apparent from the following description taken in conjunction with the accompanying drawings, in which:
FIG. 1 is a schematic cross-sectional view of an apparatus for manufacturing a display device, according to an embodiment;
FIG. 2 is a schematic plan view of a deposition source according to an embodiment;
FIG. 3 is a schematic cross-sectional view of a deposition source according to an embodiment;
FIGS. 4 to 10 are schematic cross-sectional views of a deposition source according to an embodiment;
FIG. 11 is a schematic cross-sectional view of a display device according to an embodiment;
FIG. 12 is a schematic plan view of a display device according to an embodiment;
FIG. 13 is a schematic cross-sectional view of a display device according to an embodiment; and
FIG. 14 is schematic diagram of an equivalent circuit of a pixel in a display panel, according to an embodiment.

### DETAILED DESCRIPTION OF THE EMBODIMENTS

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the invention. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc., (hereinafter individually or collectively referred to as "elements"), of the various embodiments may be otherwise combined, separated, interchanged, and/or rearranged without departing from the concepts of the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals and/or reference characters denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the X-axis, the Y-axis, and the Z-axis are not limited to three axes of a rectangular coordinate system, such as the x, y, and z axes, and may be interpreted in a broader sense. For example, the X-axis, the Y-axis, and the Z-axis may be perpendicular to one another, or may be different directions that are not perpendicular to one another.

For the purposes of this disclosure, "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc., may be used herein to describe various types of elements, these elements should not be limited by these terms. These terms are used to distinguish one element from another element. Thus, a first element discussed below could be termed a second element without departing from the teachings of the invention.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, parts, and/or modules. Those skilled in the art will appreciate that these blocks, parts, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, parts, and/or modules being implemented by microprocessors or other similar hardware, they may be programmed and controlled using software (e.g., microcode) to perform various functions discussed herein and may optionally be driven by firmware and/or software. It is also contemplated that each block, part, and/or module may be implemented by dedicated hardware, or as a combination of dedicated hardware to perform some functions and a processor (e.g., one or more programmed microprocessors and associated circuitry) to perform other functions. Also, each block, part, and/or module of some embodiments may be physically separated into two or more interacting and discrete blocks, parts, and/or modules without departing from the scope of the concepts of the invention. Further, the blocks, parts, and/or modules of some embodiments may be physically combined into more complex blocks, parts, and/or modules without departing from the scope of the concepts of the invention.

Unless otherwise defined or implied herein, all terms (including technical and scientific terms) used herein have the same meaning as commonly understood by those skilled in the art to which this invention pertains. It will be further understood that terms, such as those defined in commonly used dictionaries, should be interpreted as having a meaning that is consistent with their meaning in the context of the relevant art and the invention, and should not be interpreted in an ideal or excessively formal sense unless clearly so defined herein.

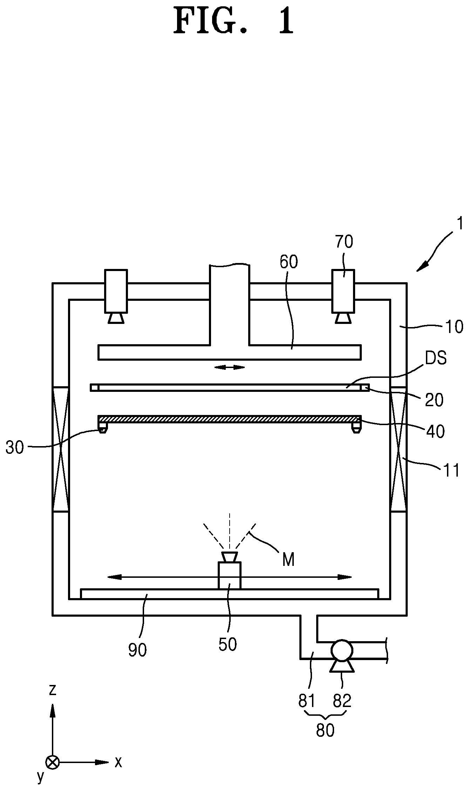

FIG. 1 is a schematic cross-sectional view of an apparatus 1 for manufacturing a display device, according to an embodiment.

The apparatus 1 may include a chamber 10, a first support part 20, a second support part 30, a mask assembly 40, a deposition source 50, a magnetic force part 60, a vision part 70, a pressure adjusting part 80, and a moving part 90.

The chamber 10 may provide an internal space. The first support part 20, the second support part 30, the mask assembly 40, the deposition source 50, the magnetic force part 60, the vision part 70, the pressure adjusting part 80, and the moving part 90 may be arranged in the internal space of the chamber 10. Here, a portion of the chamber 10 may be opened and a gate valve 11 may be provided at the opened portion of the chamber 10. The opened portion of the chamber 10 may be opened or closed according to an operation of the gate valve 11.

A display substrate DS may denote the display substrate DS during manufacturing of a display device, wherein at least one layer from among an organic layer, an inorganic layer, and a metal layer may be deposited on a substrate 100 described below. For example, the display substrate DS may be the substrate 100 on which none of the organic layer, the inorganic layer, and the metal layer has been deposited yet.

The first support part 20 may support the display substrate DS. Here, the first support part 20 may be in the form of a plate fixed inside the chamber 10. According to an embodiment, the first support part 20 may be in the form of a shuttle where the display substrate DS may be mounted and which may move linearly inside the chamber 10. According to an embodiment, the first support part 20 may include an electrostatic chuck or adhesive chuck arranged in the chamber 10 so as to be fixed to or movable inside the chamber 10.

The second support part 30 may support the mask assembly 40. Here, the second support part 30 may be arranged inside the chamber 10. The second support part 30 may minutely adjust a location of the mask assembly 40. Here, the second support part 30 may include a separate driving part or alignment part to move the mask assembly 40 in different directions.

According to an embodiment, the second support part 30 may be in the form of a shuttle. The mask assembly 40 may be mounted on the second support part 30 and the second support part 30 may transfer the mask assembly 40. For example, the second support part 30 may move to the outside of the chamber 10 and then enter from the outside of the chamber 10 into the chamber 10 after the mask assembly 40 may be mounted.

The first support part 20 and the second support part 30 may be integral with each other. The first support part 20 and the second support part 30 may include a movable shuttle. Here, the first support part 20 and the second support part 30 include a structure that fixes the mask assembly 40 and the display substrate DS while the display substrate DS may be mounted on the mask assembly 40, and may linearly move the display substrate DS and the mask assembly 40 simultaneously.

Hereinafter, for convenience of description, an embodiment in which the first support part 20 and the second support part 30 may be formed distinguished from each other and located at different locations, and an embodiment in which the first support part 20 and the second support part 30 may be arranged inside the chamber 10 will be described in detail.

The mask assembly 40 may be arranged to face the display substrate DS inside the chamber 10. A deposition material M may be deposited on the display substrate DS by passing through the mask assembly 40.

The deposition source 50 may be arranged to face the mask assembly 40 and supply the deposition material M such that the deposition material M may be deposited on the display substrate DS by passing through a deposition area of the mask assembly 40. Here, the deposition source 50 may evaporate or sublimate the deposition material M by applying heat to the deposition material M.

The magnetic force part 60 may be arranged inside the chamber 10 to face the display substrate DS and/or the mask assembly 40. Here, the magnetic force part 60 may apply magnetic force to the mask assembly 40 to press the mask assembly 40 towards the display substrate DS. In particular, the magnetic force part 60 may not only prevent sagging of the mask assembly 40, but also bring the mask assembly 40 close to the display substrate DS. Also, the magnetic force part 60 may uniformly maintain an interval between the mask assembly 40 and the display substrate DS.

The vision part 70 may be arranged in the chamber 10 and may photograph locations of the display substrate DS and the mask assembly 40. Here, the vision part 70 may include a camera configured to photograph the display substrate DS and the mask assembly 40. The locations of the display substrate DS and the mask assembly 40 may be determined based on an image captured by the vision part 70, and modification of the mask assembly 40 may be identified. The location of the display substrate DS on the first support part 20 may be minutely adjusted or the location of the mask assembly 40 on the second support part 30 may be minutely adjusted based on the image. Hereinafter, a case where the location of the mask assembly 40 on the second support part 30 is minutely adjusted to align the locations of the display substrate DS and the mask assembly 40 will be described in detail.

The pressure adjusting part 80 may extend (or be connected) to the chamber 10 and adjust pressure inside the chamber 10. For example, the pressure adjusting part 80 may maintain the pressure inside the chamber 10 to be a same as or similar to atmospheric pressure. Also, the pressure adjusting part 80 may maintain the pressure inside the chamber 10 to be a same as or similar to a vacuum state.

The pressure adjusting part 80 may include a connection pipe 81 extending to the chamber 10 and a pump 82 provided at the connection pipe 81. Here, external air may be introduced through the connection pipe 81 or a gas inside the chamber 10 may be guided to the outside through the connection pipe 81 according to an operation of the pump 82.

The moving part 90 may move the deposition source 50 in a first direction (e.g., a -x-axis direction) and a second direction (e.g., a +x-axis direction) relative to the display substrate DS. Here, the first direction (e.g., the -x-axis direction) and the second direction (e.g., the +x-axis direction) may be opposite directions.

For example, as shown in FIG. 1, a side (e.g., single side) of the moving part 90 may be fixed to the chamber 10 and the moving part 90 may move the deposition source 50 in the first direction (e.g., the -x-axis direction) and the second direction (e.g., the +x-axis direction) with respect to the chamber 10. However, this is only an example and the arrangement of the moving part 90 is not limited thereto.

For example, unlike that shown in FIG. 1, the deposition source 50 may be fixed to the chamber 10 and the moving part 90 may move the display substrate DS in the first direction (e.g., the -x-axis direction) and the second direction (e.g., the +x-axis direction) with respect to the chamber 10. For example, the moving part 90 may move the magnetic force part 60 and the mask assembly 40 in the first direction (e.g., the -x-axis direction) and the second direction (e.g., the +x-axis direction) with respect to the chamber 10.

Referring to a method of manufacturing a display device by using the apparatus 1, the display substrate DS may first be prepared.

The pressure adjusting part 80 may maintain the inside of the chamber 10 to be same as or similar to atmospheric pressure, and the opened portion of the chamber 10 may be opened in case that the gate valve 11 is activated.

Then, the display substrate DS may enter the chamber 10 from the outside of the chamber 10. The display substrate DS may enter the chamber 10 in various manners. For example, the display substrate DS may enter the chamber 10 from the outside of the chamber 10 through a robot arm or the like arranged outside the chamber 10. According to an embodiment, in case that the first support part 20 is in the form of a shuttle, the first support part 20 may be taken outside the chamber 10 from the inside of the chamber 10, the display substrate DS may be mounted on the first support part 20 through a separate robot arm or the like arranged outside the chamber 10, and then the first support part 20 may enter the chamber 10 from the outside of the chamber 10.

The mask assembly 40 may be arranged inside the chamber 10 as described above. According to an embodiment, the mask assembly 40 may enter the chamber 10 from the outside the chamber 10 in a same or similar manner as the display substrate DS.

In case that the display substrate DS enters the chamber 10, the display substrate DS may be mounted on the first support part 20. Here, the vision part 70 may photograph the locations of the display substrate DS and the mask assembly 40. The locations of the display substrate DS and the mask assembly 40 may be determined based on an image captured by the vision part 70. Here, the apparatus 1 may include a separate controller to determine the locations of the display substrate DS and the mask assembly 40.

In case that the locations of the display substrate DS and the mask assembly 40 are determined, the second support part 30 may minutely adjust the location of the mask assembly 40.

Then, the deposition source 50 may be activated to supply the deposition material M to the mask assembly 40, and the deposition material M that has passed through multiple pattern holes of the mask assembly 40 may be deposited on the display substrate DS. Here, the deposition source 50 may move in parallel to the display substrate DS and the mask assembly 40 or the display substrate DS and the mask assembly 40 may move in parallel to the deposition source 50 by the moving part 90. In other words, the deposition source 50 may move relative to the display substrate DS and the mask assembly 40 by the moving part 90. Here, the pump 82 may suck up gas inside the chamber 10 and discharge the gas to the outside, thereby maintaining the pressure inside the chamber 10 to be a same as or similar to vacuum.

As described above, the deposition material M supplied from the deposition source 50 may be deposited on the display substrate DS by passing through the mask assembly 40, and accordingly, multiple layers stacked on each other on a display device, for example, at least one of an organic layer, an inorganic layer, and a metal layer, described below, may be formed.

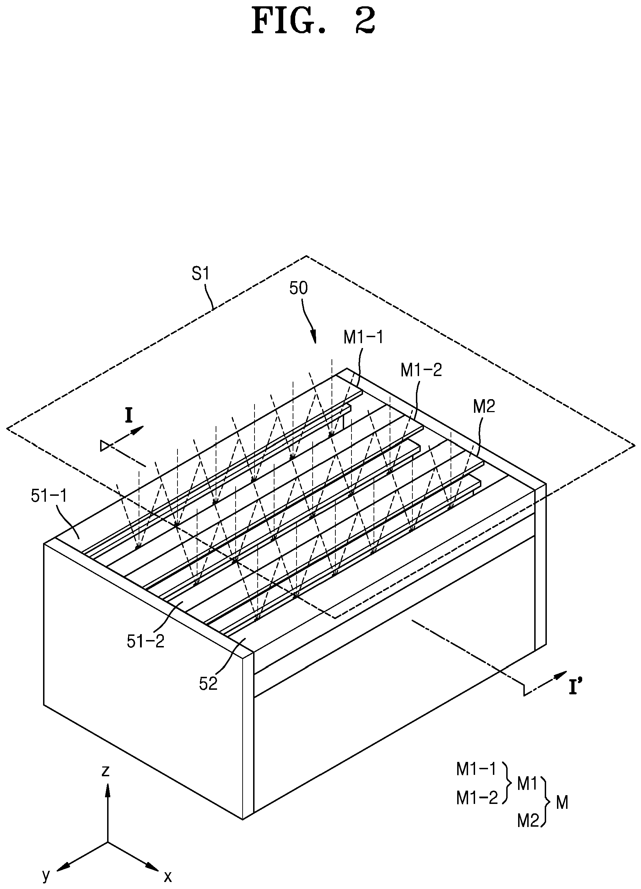

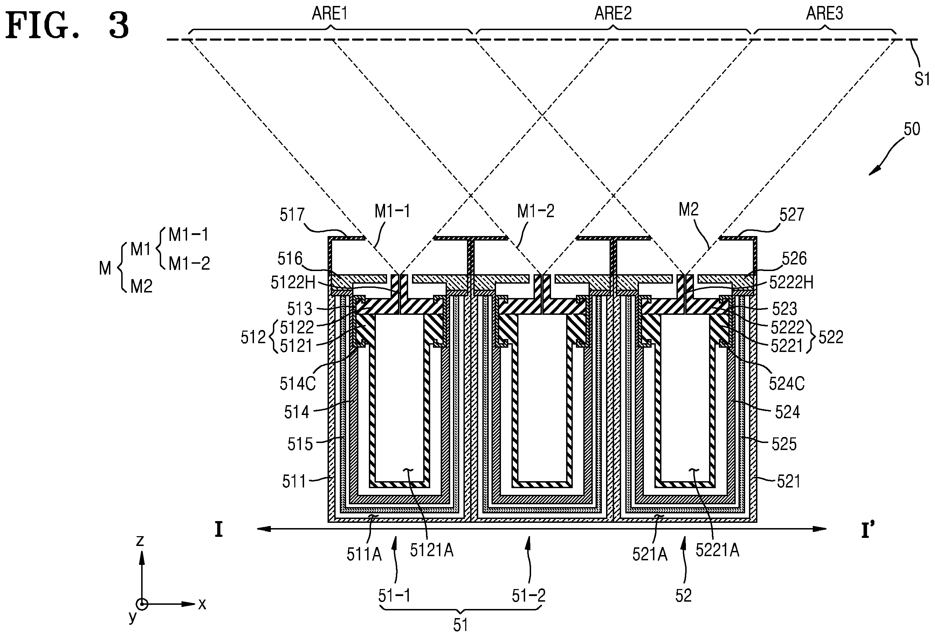

FIG. 2 is a schematic plan view of the deposition source 50 according to an embodiment, and FIG. 3 is a schematic cross-sectional view of the deposition source 50 according to an embodiment.

In particular, FIG. 3 may correspond to a portion I-I' of FIG. 2.

Referring to FIGS. 1 to 3, the deposition source 50 according to an embodiment may eject the deposition material M including a first deposition material M1 and a second deposition material M2.

The deposition source 50 may include a first deposition part 51 configured to supply the first deposition material M1, and a second deposition part 52 configured to supply the second deposition material M2.

A virtual plane (or surface) in the internal space of the chamber 10, where the display substrate DS is arranged will be referred to as a virtual plane S1. Accordingly, while the apparatus 1 deposits the deposition material M on the display substrate DS, a lower surface of the display substrate DS and virtual plane S1 may coincide with each other. In other words, the apparatus 1 may deposit the deposition material M on the display substrate DS arranged on (or coincides with) the virtual plane S1.

The first deposition part 51 may eject the first deposition material M1 towards the display substrate DS. The first deposition part 51 may supply the first deposition material M1 such that the first deposition material M1 passes through the mask assembly 40 and may be deposited on the display substrate DS. The first deposition part 51 may include a first deposition frame 511, a first ejection part 512, a first adhesion part 513, a first support part 514, a first heating part 515, a first reflector 516, and a first angle limiting part 517.

The first deposition frame 511 may form an outer appearance of the first deposition part 51 and provide a first internal space 511A. A side (e.g., single side) of the first deposition frame 511 may be opened so that the first deposition material M1 may be externally ejected. The first deposition frame 511 may include a cooling device. In such a structure, the first deposition frame 511 may cool down heat generated in the first internal space 511A. Accordingly, the first deposition frame 511 may reduce a phenomenon in which heat generated in the first internal space 511A may be externally discharged, thereby affecting other components including a mask frame and a substrate. In FIGS. 2 and 3, the first deposition frame 511 has a hexagonal shape with a side (e.g., single side) open, but this is only an example and a shape of the first deposition frame 511 is not limited thereto.

The first ejection part 512 may be accommodated in the first internal space 511A of the first deposition frame 511 and may eject the first deposition material M1 stored therein. The first ejection part 512 may include a first crucible part 5121 and a first nozzle part 5122.

The first crucible part 5121 may provide a first storage space 5121A storing the first deposition material M1. The first deposition material M1 may be accommodated in the first storage space 5121A of the first crucible part 5121. The first nozzle part 5122 may extend (or be connected) to the first crucible part 5121 and may eject the first deposition material M1 stored in the first storage space 5121A of the first crucible part 5121. A first ejection hole 5122H ejecting the first deposition material M1 may be arranged in the first nozzle part 5122. The first storage space 5121A of the first crucible part 5121 may communicate with the first ejection hole 5122H of the first nozzle part 5122.

The first adhesion part 513 may be accommodated in the first internal space 511A of the first deposition frame 511 to adhere the first crucible part 5121 and the first nozzle part 5122 to each other. The first adhesion part 513 may adhere the first crucible part 5121 and the first nozzle part 5122 to each other by applying pressure to at least one of the first crucible part 5121 and the first nozzle part 5122. Accordingly, the first deposition material M1 may be prevented from leaking between the first crucible part 5121 and the first nozzle part 5122 while the first deposition material M1 is ejected.

The first support part 514 may support the first ejection part 512 from the first deposition frame 511. The first support part 514 may be accommodated in the first internal space 511A of the first deposition frame 511. A side (e.g., single side) of the first support part 514 may be fixed to the first deposition frame 511 such that the first support part 514 may be supported by the first deposition frame 511. The first support part 514 may support the first adhesion part 513 to support the first ejection part 512 fixed to the first adhesion part 513. For example, a side (e.g., single side) of the first adhesion part 513 may be supported by being caught on a first step 514C arranged in the first support part 514 while the first ejection part 512 and the first adhesion part 513 may be accommodated in the first support part 514. However, this is only an example and a manner in which the first support part 514 supports the first ejection part 512 is not limited thereto.

The first heating part 515 may be accommodated in the first internal space 511A of the first deposition frame 511 to heat the first nozzle part 5122. The first heating part 515 may be arranged to surround the first ejection part 512, the first adhesion part 513, and the first support part 514. The first heating part 515 may be provided between the first support part 514 and the first deposition frame 511. For example, as shown in FIG. 3, a schematic cross-sectional shape of the first heating part 515 may include a "U" shape and the first ejection part 512 may be accommodated inside the first heating part 515. For example, the first heating part 515 may be supported by the first deposition frame 511 by being fixed to the first support part 514. However, this is only an example and the arrangement and shape of the first heating part 515 is not limited thereto.

The first deposition material M1 accommodated in the first crucible part 5121 may be heated by the first heating part 515. The first heating part 515 may heat a side surface (e.g., a surface facing an x-axis direction) and a lower surface (e.g., a surface facing a -z-axis direction) of the first ejection part 512. In case that the first heating part 515 heats the first deposition material M1, the first deposition material M1 accommodated in the first crucible part 5121 may evaporate. Accordingly, the first deposition material M1 evaporated by the first heating part 515 may be ejected by the first nozzle part 5122.

For example, the first heating part 515 may include a heating member configured to generate heat. The heating member may generate heat (e.g., directly generate heat). For example, a heating wire generating heat may be arranged on a surface of the first heating part 515, which faces the first nozzle part 5122. However, this is only an example and a method by which the first heating part 515 heats the first nozzle part 5122 is not limited thereto.

The first reflector 516 may block heat generated in the first internal space 511A of the first deposition frame 511 from being transferred to the mask assembly 40. The first reflector 516 may be provided between the first heating part 515 and the mask assembly 40. In such a structure, the first reflector 516 may prevent the mask assembly 40 or the display substrate DS from being damaged by heat as heat may be transferred from the first heating part 515 to the mask assembly 40. Also, heat efficiency of the first heating part 515 may increase by reducing external discharge of heat generated in the first internal space 511A of the first deposition frame 511.

The first reflector 516 may extend (or be connected) to the first deposition frame 511. In case that the first deposition frame 511 includes the cooling device, the first deposition frame 511 may cool down the first reflector 516. In such a structure, the first reflector 516 may efficiently block heat generated in the first internal space 511A of the first deposition frame 511 from being transferred to the mask assembly 40.

The first angle limiting part 517 may extend (or be connected) to the first deposition frame 511 and may limit a supply angle of the first deposition material M1 supplied to the mask assembly 40. A portion of the first deposition material M1 ejected by the first nozzle part 5122 may be blocked from being supplied to the display substrate DS by the first angle limiting part 517. In other words, the first angle limiting part 517 may limit the supply angle of the first deposition material M1 by allowing only the first deposition material M1 with a supply angle of a designated range to pass through.

The second deposition part 52 may eject the second deposition material M2 towards the display substrate DS. The second deposition part 52 may supply the second deposition material M2 such that the second deposition material M2 passes through the mask assembly 40 and is deposited on the display substrate DS. The second deposition part 52 may include a second deposition frame 521, a second ejection part 522, a second adhesion part 523, a second support part 524, a second heating part 525, a second reflector 526, and a second angle limiting part 527.

The second deposition frame 521 may form an outer appearance of the second deposition part 52 and provide a second internal space 521A. A side (e.g., single side) of the second deposition frame 521 may be opened so that the second deposition material M2 may be externally ejected. The second deposition frame 521 may include a cooling device. In such a structure, the second deposition frame 521 may cool down heat generated in the second internal space 521A. Accordingly, the second deposition frame 521 may reduce a phenomenon in which heat generated in the second internal space 521A is externally discharged, thereby affecting other components including a mask frame and a substrate. In FIGS. 2 and 3, the second deposition frame 521 has a hexagonal shape with a side (e.g., single side) open, but this is only an example and a shape of the second deposition frame 521 is not limited thereto.

The second ejection part 522 may be accommodated in the second internal space 521A of the second deposition frame 521 and may eject the second deposition material M2 stored therein. The second ejection part 522 may include a second crucible part 5221 and a second nozzle part 5222.

The second crucible part 5221 may provide a second storage space 5221A storing the second deposition material M2. The second deposition material M2 may be accommodated in the second storage space 5221A of the second crucible part 5221. The second nozzle part 5222 may extend (or be connected) to the second crucible part 5221 and may eject the second deposition material M2 stored in the second storage space 5221A of the second crucible part 5221. A second ejection hole 5222H ejecting the second deposition material M2 may be arranged in the second nozzle part 5222. The second storage space 5221A of the second crucible part 5221 may communicate with the second ejection hole 5222H of the second nozzle part 5222.

The second adhesion part 523 may be accommodated in the second internal space 521A of the second deposition frame 521 to adhere the second crucible part 5221 and the second nozzle part 5222 to each other. The second adhesion part 523 may adhere the second crucible part 5221 and the second nozzle part 5222 to each other by applying pressure to at least one of the second crucible part 5221 and the second nozzle part 5222. Accordingly, the second deposition material M2 may be prevented from leaking between the second crucible part 5221 and the second nozzle part 5222 while the second deposition material M2 is ejected.

The second support part 524 may support the second ejection part 522 from the second deposition frame 521. The second support part 524 may be accommodated in the second internal space 521A of the second deposition frame 521. A side (e.g., single side) of the second support part 524 may be fixed to the second deposition frame 521 such that the second support part 524 may be supported by the second deposition frame 521. The second support part 524 may support the second adhesion part 523 to support the second ejection part 522 fixed to the second adhesion part 523. For example, a side (e.g., single side) of the second adhesion part 523 may be supported by being caught on a second step 524C arranged in the second support part 524 while the second ejection part 522 and the second adhesion part 523 are accommodated in the second support part 524. However, this is only an example and a manner in which the second support part 524 supports the second ejection part 522 is not limited thereto.

The second heating part 525 may be accommodated in the second internal space 521A of the second deposition frame 521 to heat the second nozzle part 5222. The second heating part 525 may be arranged to surround the second ejection part 522, the second adhesion part 523, and the second support part 524. The second heating part 525 may be provided between the second support part 524 and the second deposition frame 521. For example, as shown in FIG. 3, a cross-sectional shape of the second heating part 525 may include a "U" shape and the second ejection part 522 may be accommodated inside the second heating part 525. For example, the second heating part 525 may be supported by the second deposition frame 521 by being fixed to the second support part 524. However, this is only an example and the arrangement and shape of the second heating part 525 is not limited thereto.

The second deposition material M2 accommodated in the second crucible part 5221 may be heated by the second heating part 525. The second heating part 525 may heat a side surface (e.g., a surface facing the x-axis direction) and a lower surface (e.g., a surface facing the -z-axis direction) of the second ejection part 522. In case that the second heating part 525 heats the second deposition material M2, the second deposition material M2 accommodated in the second crucible part 5221 may evaporate. Accordingly, the second deposition material M2 evaporated by the second heating part 525 may be ejected by the second nozzle part 5222.

For example, the second heating part 525 may include a heating member configured to generate heat. The heating member may generate heat (e.g., directly generate heat). For example, a heating wire generating heat may be arranged on a surface of the second heating part 525 which faces the second nozzle part 5222. However, this is only an example and a method by which the second heating part 525 heats the second nozzle part 5222 is not limited thereto.

The second reflector 526 may block heat generated in the second internal space 521A of the second deposition frame 521 from being transferred to the mask assembly 40. The second reflector 526 may be provided between the second heating part 525 and the mask assembly 40. In such a structure, the second reflector 526 may prevent the mask assembly 40 or the display substrate DS from being damaged by heat as heat may be transferred from the second heating part 525 to the mask assembly 40. Also, heat efficiency of the second heating part 525 may increase by reducing external discharge of heat generated in the second internal space 521A of the second deposition frame 521.

The second reflector 526 may extend (or be connected) to the second deposition frame 521. In case that the second deposition frame 521 includes the cooling device, the second deposition frame 521 may cool down the second reflector 526. In such a structure, the second reflector 526 may efficiently block heat generated in the second internal space 521A of the second deposition frame 521 from being transferred to the mask assembly 40.

The second angle limiting part 527 may extend (or be connected) to the second deposition frame 521 and may limit a supply angle of the second deposition material M2 supplied to the mask assembly 40. A portion of the second deposition material M2 ejected by the second nozzle part 5222 may be blocked from being supplied to the display substrate DS by the second angle limiting part 527. In other words, the second angle limiting part 527 may limit the supply angle of the second deposition material M2 by allowing only the second deposition material M2 with a supply angle of a designated range to pass through.

The first deposition part 51 and the second deposition part 52 may be arranged in parallel to each other. The first deposition part 51 and the second deposition part 52 may each eject the deposition material M in a third direction (e.g., a +z-axis direction) facing the virtual plane S1. Here, the third direction may be a direction crossing the first direction (e.g., the -x-axis direction) and the second direction (e.g., the +x-axis direction). The first deposition material M1 ejected by the first deposition part 51 may be different from the second deposition material M2 ejected by the second deposition part 52. The virtual plane S1 may include a first area (or first region) ARE1, a second area (or second region) ARE2, and a third area (or third region) ARE3. The first area ARE1, the second area ARE2, and the third area ARE3 are defined with respect to a location of the deposition source 50 and move together with the deposition source across virtual plane S1 that may include the display substrate DS. In case that at least one of the first area ARE1, the second area ARE2, and the third area ARE3 coincide with the display substrate DS, one or both of first deposition material M1 and second deposition M2 may be deposited on the display substrate DS.

The first deposition material M1 may reach the first area ARE1 and the first area ARE1 may be spaced apart from the second deposition material M2. The second deposition material M2 may not reach the first area ARE1. In other words, only the first deposition material M1 may reach the first area ARE1.

The first deposition material M1 and the second deposition material M2 may each reach the second area ARE2. The first deposition material M1 and the second deposition material M2 may overlap each other in the second area ARE2. The first deposition material M1 and the second deposition material M2 may be mixed with each other in the second area ARE2.

The second deposition material M2 may reach the third area ARE3 and the third area ARE3 may be spaced apart from the first deposition material M1. The first deposition material M1 may not reach the third area ARE3. In other words, only the second deposition material M2 may reach the third area ARE3.

There may be multiple the first deposition parts 51. For example, the first deposition parts 51 may include a first-1 deposition part 51-1 and a first-2 deposition part 51-2. The first-1 deposition part 51-1 and the first-2 deposition part 51-2 may eject a same material. The first-1 deposition part 51-1 may eject a first-1 deposition material M1-1 and the first-2 deposition part 51-2 may eject a first-2 deposition material M1-2. The first-1 deposition material M1-1 and the first-2 deposition material M1-2 may be a same material. The first-1 deposition part 51-1, the first-2 deposition part 51-2, and the second deposition part 52 may be arranged in a linear manner.

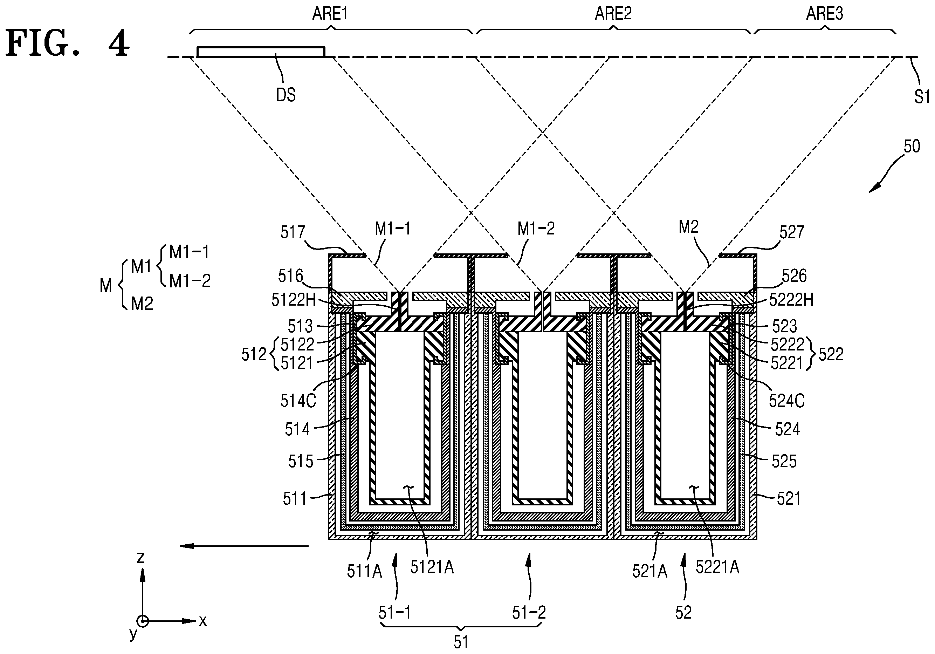

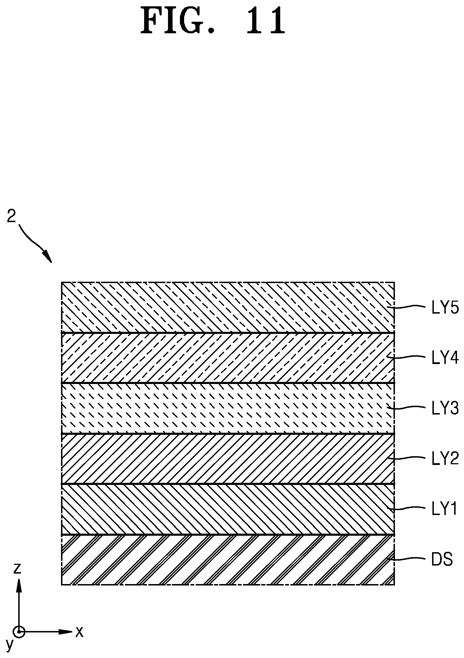

FIGS. 4 to 10 are schematic cross-sectional views of the deposition source 50 according to an embodiment, and FIG. 11 is a schematic cross-sectional view of a display device 2 according to an embodiment.

In FIGS. 4 to 11, like reference numerals as FIGS. 1 to 3 denote like elements, and thus redundant descriptions thereof may be omitted.

Referring to FIGS. 4 to 11, a method by which the apparatus 1 manufactures the display device 2 is described. In case that the deposition source 50 moves sequentially in the first direction (e.g., the -x-axis direction) and the second direction (e.g., the +x-axis direction) relative to the display substrate DS, the display substrate DS may sequentially pass through the first area ARE1, the second area ARE2, the third area ARE3, the second area ARE2, and the first area ARE1 of virtual plane S1.

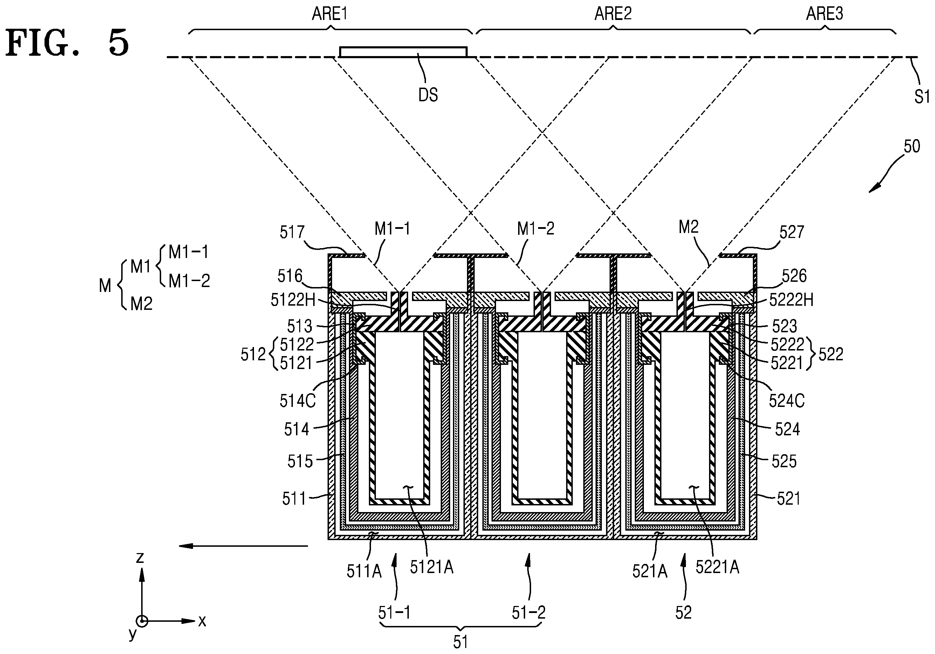

In detail, as shown in FIGS. 4 and 5, in case that the deposition source 50 moves in the first direction (e.g., the -x-axis direction) relative to the display substrate DS, the display substrate DS may pass through the first area ARE1. As shown in FIGS. 4, 5, and 11, in case that the display substrate DS passes through the first area ARE1, a first layer LY1 including the first deposition material M1 may be deposited on the display substrate DS.

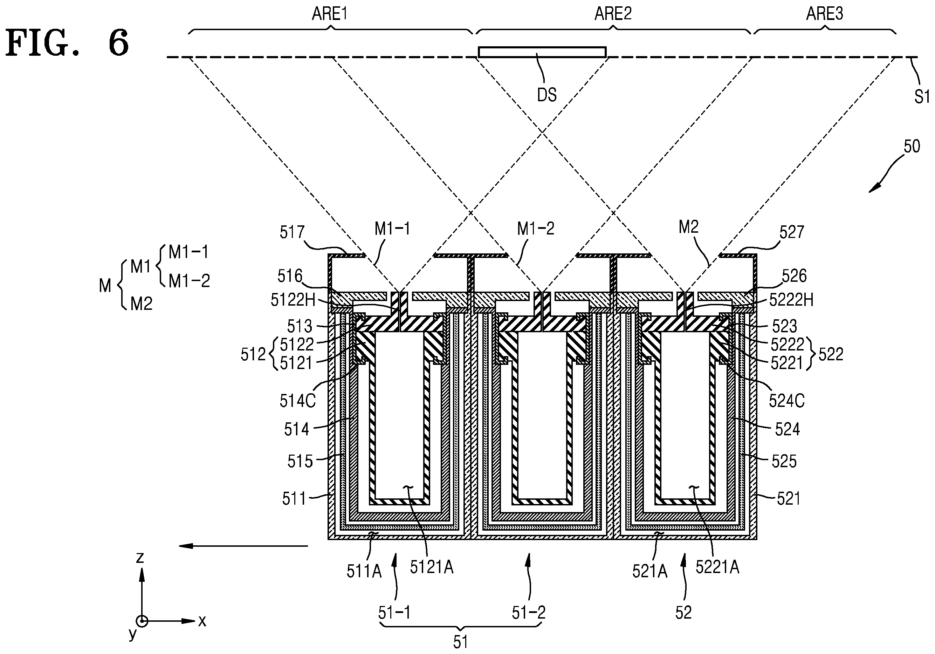

As shown in FIG. 6, in case that the deposition source 50 moves in the first direction (e.g., the -x-axis direction) relative to the display substrate DS, the display substrate DS may pass through the second area ARE2. As shown in FIGS. 6 and 11, in case that the display substrate DS passes through the second area ARE2, a second layer LY2 including the first deposition material M1 and the second deposition material M2 may be deposited on the display substrate DS. In the second layer LY2, the concentration of the second deposition material M2 may gradually increase in a direction towards a third layer LY3, compared to the first deposition material M1.

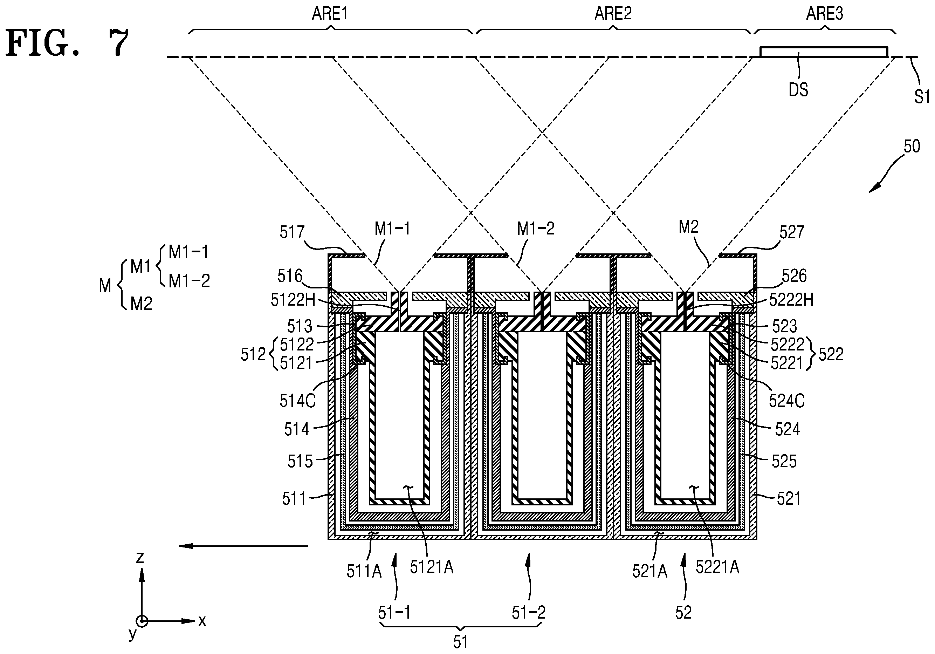

As shown in FIG. 7, in case that the deposition source 50 moves in the first direction (e.g., the -x-axis direction) relative to the display substrate DS, the display substrate DS may pass through the third area ARE3. As shown in FIGS. 7 and 11, in case that the display substrate DS passes through the third area ARE3, the third layer LY3 including the second deposition material M2 may be deposited on the display substrate DS.

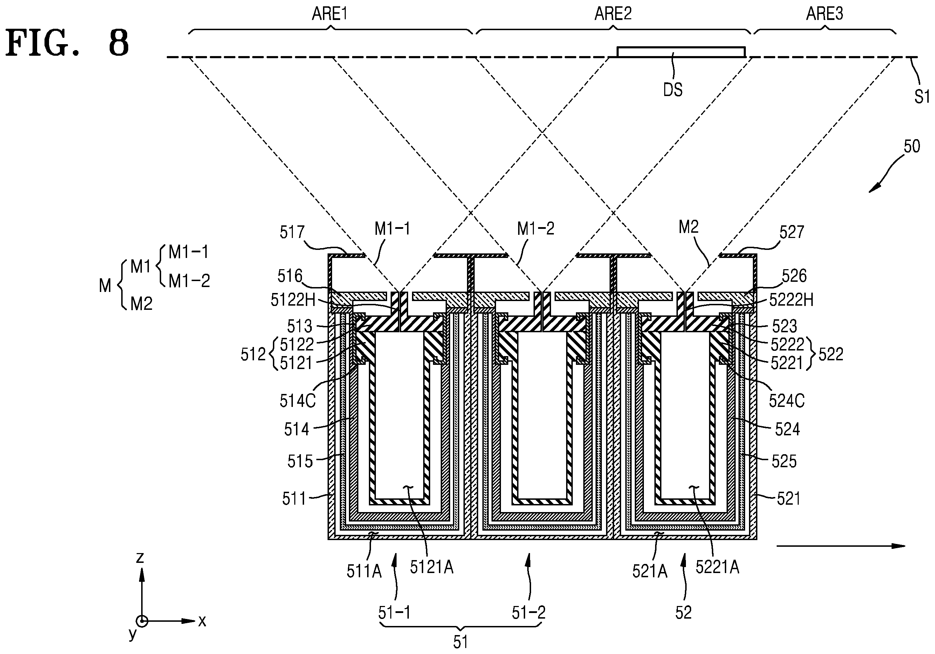

As shown in FIG. 8, in case that the deposition source 50 moves in the second direction (e.g., the +x-axis direction) relative to the display substrate DS, the display substrate DS may pass through the second area ARE2 again. As shown in FIGS. 8 and 11, in case that the display substrate DS passes through the second area ARE2 again, a fourth layer LY4 including the first deposition material M1 and the second deposition material M2 may be deposited on the display substrate DS. In the fourth layer LY4, the concentration of the first deposition material M1 may gradually increase in a direction towards a fifth layer LY5, compared to the second deposition material M2.

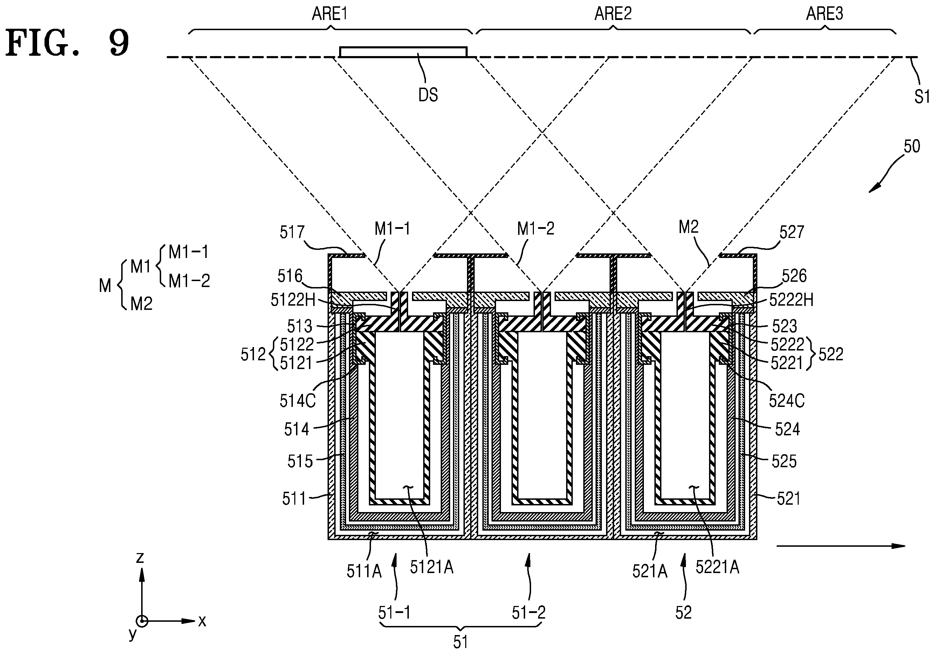

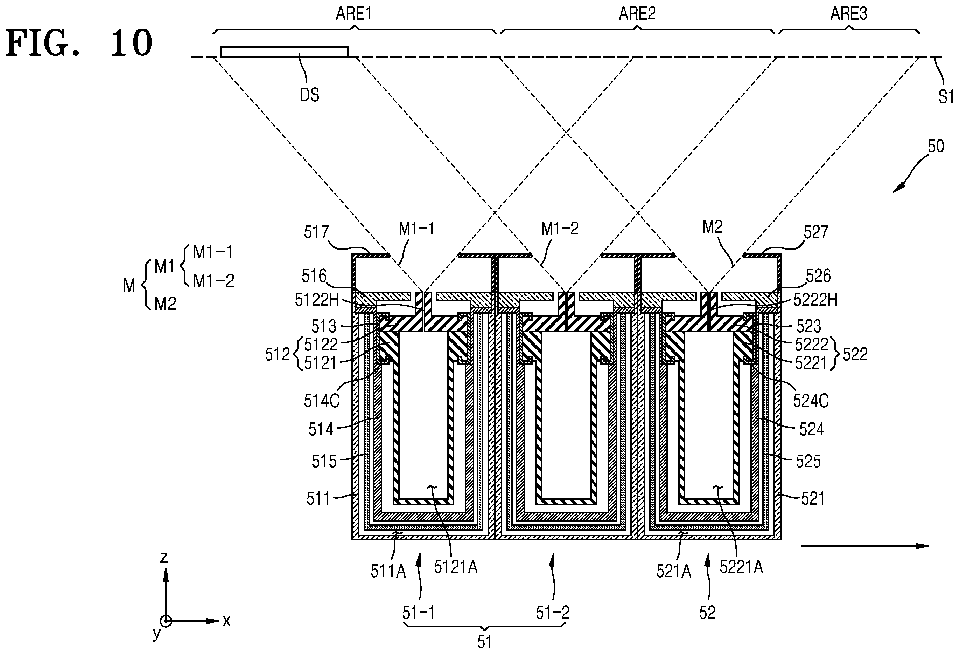

As shown in FIGS. 9 and 10, in case that the deposition source 50 moves in the second direction (e.g., the +x-axis direction) relative to the display substrate DS, the display substrate DS may pass through the first area ARE1 again. As shown in FIGS. 9 and 11, in case that the display substrate DS passes through the first area ARE1 again, the fifth layer LY5 including the first deposition material M1 may be deposited on the display substrate DS.

Each of the first deposition material M1 and the second deposition material M2 may include a capping material. For example, each of the first deposition material M1 and the second deposition material M2 may include lithium fluoride (LiF), an inorganic material, and/or an organic material. In detail, each of the first deposition material M1 and the second deposition material M2 may include a carbocyclic compound, a heterocyclic compound, an amine group-containing compound, porphine derivatives, phthalocyanine derivatives, naphthalocyanine derivatives, an alkali metal complex, an alkaline earth metal complex, or any combination thereof. The carbocyclic compound, the heterocyclic compound, and the amine group-containing compound may be selectively substituted by a substituent including oxygen (O), nitrogen (N), sulfur (S), selenium (Se), silicon (Si), fluorine (F), chlorine (Cl), bromine (Br), iodine (I), or any combination thereof.

For example, the second deposition material M2 may have a greater refractive index than the first deposition material M1. Accordingly, the third layer LY3 may have a greater refractive index than each of the first layer LY1 and the fifth layer LY5. The second layer LY2 may have a refractive index gradually increasing in a direction towards the third layer LY3. The fourth layer LY4 may have a refractive index gradually decreasing in a direction towards the fifth layer LY5. For example, the refractive index of the first layer LY1 may be in a range of about 1.0 to about 1.8, the refractive index of the third layer LY3 may be in a range of about 1.8 to about 2.4, and the refractive index of the fifth layer LY5 may be in a range of about 1.0 to about 1.8.

Also, a thickness of the fifth layer LY5 may be greater than a thickness of the first layer LY1. For example, the thickness of the first layer LY1 may be in a range of about 5 nm to about 80 nm, the thickness of the third layer LY3 may be in a range of about 20 nm to about 100 nm, and the thickness of the fifth layer LY5 may be in a range of about 5 nm to about 80 nm.

In such a structure, a light loss caused by surface plasmon polariton (SPP) of the display device 2 may decrease according to an arrangement of the first layer LY1 with a relatively low refractive index.

Also, light emitted from the display substrate DS may resonate according to arrangements of the third layer LY3 with a relatively high refractive index and the fifth layer LY5 with a relatively low refractive index. In other words, light efficiency may improve by the principle of constructive interference of light passing through the third layer LY3 and the fifth layer LY5.

As an example, the second deposition material M2 may have a lower refractive index than the first deposition material M1. Accordingly, the third layer LY3 may have a lower refractive index than each of the first layer LY1 and the fifth layer LY5. The second layer LY2 may have a refractive index gradually decreasing in the direction towards the third layer LY3. The fourth layer LY4 may have a refractive index gradually increasing in the direction towards the fifth layer LY5. For example, the refractive index of the first layer LY1 may be 1.8 to 2.4, the refractive index of the third layer LY3 may be 1.0 to 1.8, and the refractive index of the fifth layer LY5 may be 1.8 to 2.4.

However, this is only an example and a refractive index and thickness of each of the first layer LY1, the second layer LY2, the third layer LY3, the fourth layer LY4, and the fifth layer LY5 are not limited thereto. The refractive index and thickness of each of the first layer LY1, the second layer LY2, the third layer LY3, the fourth layer LY4, and the fifth layer LY5 may be variously modified according to a type and/or a size of the display device 2.

According to an embodiment described with reference to FIGS. 1 to 11, the apparatus 1 may not include a separate shutter but may alternately arrange the first deposition material M1 and the second deposition material M2, which are different materials, on the display substrate DS. Accordingly, time and costs of manufacturing the display device 2 may be reduced.

Because there is the second area ARE2 where the first deposition material M1 and the second deposition material M2 reach, angles at which the first deposition material M1 and/or the second deposition material M2 are ejected may be relatively increased compared to a case that the first deposition material M1 and the second deposition material M2 do not overlap each other. In other words, a supply angle limited by the first angle limiting part 517 and/or the second angle limiting part 527 may be relatively increased. Accordingly, a flow rate of the deposition material M may be relatively decreased in case of supplying the deposition material M of same flow quantity to the virtual plane S1. Accordingly, a material piling up phenomenon occurred in the first angle limiting part 517 and/or the second angle limiting part 527 may be reduced.

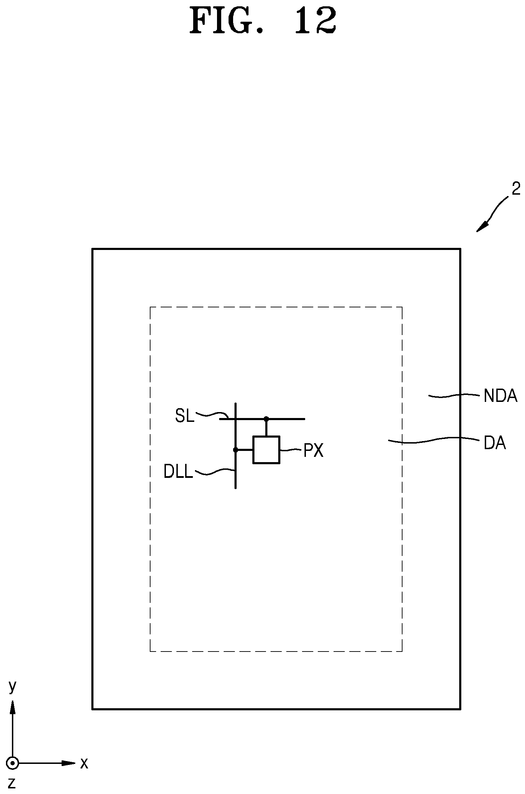

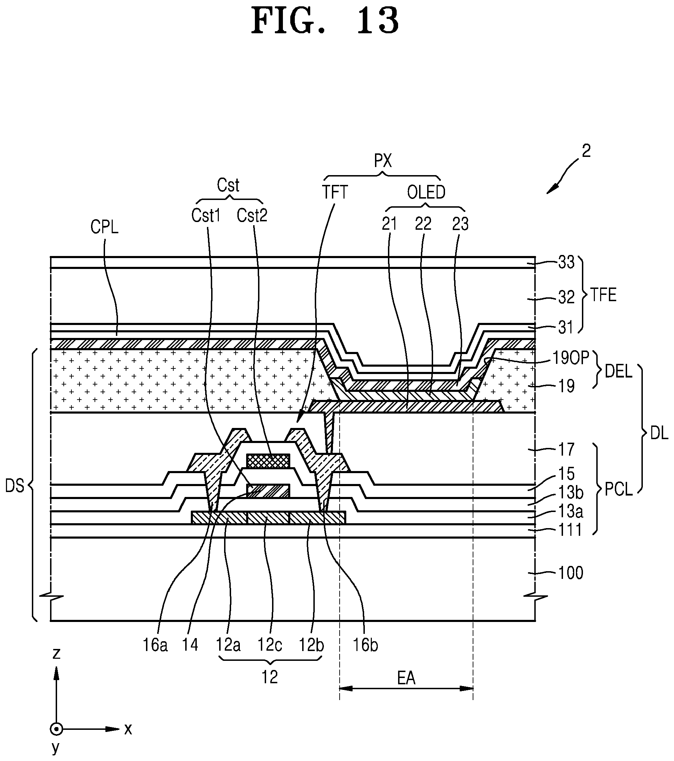

FIG. 12 is schematic a plan view of the display device 2 according to an embodiment, and FIG. 13 is a schematic cross-sectional view of the display device 2 according to an embodiment.

Referring to FIGS. 12 and 13, FIG. 12 illustrates a plan view of the display device 2 which may include a non-display area NDA surrounding a display area DA. Pixels PX may be disposed in the display area DA, and each pixel PX may be connected to a scan line SL to select the pixel for emission and a data line DLL to drive the pixel according to image data. The display device 2 may include the display substrate DS. Here, the display substrate DS may correspond to the display substrate DS described with reference to FIGS. 1 to 11. FIG. 13 is a schematic cross-sectional view of a pixel PX of FIG. 12. As illustrated in FIG. 13, the display substrate DS may include the substrate 100 and a display layer DL.

The display layer DL, a capping layer CPL, and a thin-film encapsulation layer TFE may be arranged on the substrate 100. The display layer DL may include a pixel circuit layer PCL and a display element layer DEL.

The substrate 100 may include glass or a polymer resin, such as polyethersulfone, polyarylate, polyetherimide, polyethylene naphthalate, polyethylene terephthalate, polyphenylene sulfide, polyimide, polycarbonate, cellulose triacetate, cellulose acetate propionate, or a combination thereof.

A barrier layer may be further positioned between the display layer DL and the substrate 100. The barrier layer may be a barrier layer configured to prevent penetration of an external impurity and may be a single layer or a multi-layer including an inorganic material such as a silicon nitride (SiNₓ) wherein x > 0 or a silicon oxide (SiOₓ) wherein x > 0.

The pixel circuit layer PCL may be disposed on the substrate 100. The pixel circuit layer PCL may include a thin-film transistor TFT, and buffer layer 111, a first insulating layer 13a, a second insulating layer 13b, a third insulating layer 15, and a planarization layer 17, which are disposed below and/or on components of the thin-film transistor TFT.

The buffer layer 111 may include an inorganic insulating material, such as silicon nitride, silicon oxynitride, silicon oxide, or a combination thereof, and may be a single layer or multi-layer including the above inorganic insulating material.

The thin-film transistor TFT may include a semiconductor layer 12, and the semiconductor layer 12 may include polysilicon. As another example, the semiconductor layer 12 may include amorphous silicon, an oxide semiconductor, or an organic semiconductor. The semiconductor layer 12 may include a channel region 12c, and a drain region 12a and a source region 12b, which are arranged respectively on both sides of the channel region 12c. A gate electrode 14 may overlap the channel region 12c.

The gate electrode 14 may include a low-resistance metal material. The gate electrode 14 may include a conductive material including molybdenum (Mo), aluminum (Al), copper (Cu), titanium (Ti), or a combination thereof, and may be formed in a multi-layer or single layer including the conductive material.

The first insulating layer 13a between the semiconductor layer 12 and the gate electrode 14 may include an inorganic insulating material, such as silicon oxide (SiO₂), silicon nitride (SiNₓ), silicon oxynitride (SiON), aluminum oxide (Al₂O₃), titanium oxide (TiO₂), tantalum oxide (Ta₂O₅), hafnium oxide (HfO₂), and/or zinc oxide (ZnO₂).

The second insulating layer 13b may be provided to cover the gate electrode 14. Like the first insulating layer 13a, the second insulating layer 13b may include an inorganic insulating material, such as SiO₂, SiNₓ, SiON, Al₂O₃, TiO₂, Ta₂O₅, HfO₂, ZnO₂, or a combination thereof.

An upper electrode Cst2 of a storage capacitor Cst may be disposed on the second insulating layer 13b. The upper electrode Cst2 may overlap the gate electrode 14 below the upper electrode Cst2. Here, the gate electrode 14 and the upper electrode Cst2, which overlaps the second insulating layer 13b between the gate electrode 14 and the upper electrode Cst2, may form the storage capacitor Cst. In other words, the gate electrode 14 may operate as a lower electrode Cst1 of the storage capacitor Cst.

As such, the storage capacitor Cst and the thin-film transistor TFT may overlap each other. According to some embodiments, the storage capacitor Cst may not overlap the thin-film transistor TFT.

The upper electrode Cst2 may include aluminum (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), and/or copper (Cu), and may be a single layer or multi-layer including such a material.

The third insulating layer 15 may be provided to cover the upper electrode Cst2. The third insulating layer 15 may include SiO₂, SiN_{X}, SiON, Al₂O₃, TiO₂, Ta₂O₅, HfO₂, ZnO₂, or a combination thereof. The third insulating layer 15 may be a single layer or multi-layer including the inorganic insulating material described above.

**A** drain electrode 16a and a source electrode 16b may each be located on the third insulating layer 15. The drain electrode 16a and the source electrode 16b may include a material having good conductivity. The drain electrode 16a and the source electrode 16b may include a conductive material including Mo, Al, Cu, Ti, or a combination thereof, and may be formed in a multi-layer or single layer including the above material. According to an embodiment, the drain electrode 16a and the source electrode 16b may have a multi-layer structure of Ti/Al/Ti.

The planarization layer 17 may include an organic insulating layer. The planarization layer 17 may include an organic insulating material, such as a general-purpose polymer, for example, polymethylmethacrylate (PMMA) or polystyrene (PS), a polymer derivate having a phenol-based group, an acrylic-based polymer, an imide-based polymer, an aryl ether-based polymer, an amide-based polymer, a fluorine-based polymer, a p-xylene-based polymer, a vinyl alcohol-based polymer, or a blend thereof.

The display element layer DEL may be disposed on the pixel circuit layer PCL having the above-described structure. The display element layer DEL may include an organic light-emitting diode OLED, wherein a pixel electrode 21 of the organic light-emitting diode OLED may be electrically connected to the thin-film transistor TFT through a contact hole defined in the planarization layer 17.

A pixel PX may include the organic light-emitting diode OLED and the thin-film transistor TFT. Each pixel PX may be configured to emit, for example, red, green, or blue light or red, green, blue, or white light through the organic light-emitting diode OLED.

The pixel electrode 21 may include a conductive oxide, such as indium tin oxide (ITO), indium zinc oxide (IZO), zinc oxide (ZnO), indium oxide (In₂O₃), indium gallium oxide (IGO), aluminum zinc oxide (AZO), or a combination thereof. According to an embodiment, the pixel electrode 21 may include a reflective layer including silver (Ag), magnesium (Mg), aluminum (Al), platinum (Pt), palladium (Pd), gold (Au), nickel (Ni), neodymium (Nd), iridium (Ir), chromium (Cr), a compound thereof, or a combination thereof. According to an embodiment, the pixel electrode 21 may further include a layer formed of ITO, IZO, ZnO, or In₂O₃, on/below the reflective layer.

A pixel-defining layer 19 having an opening 19OP exposing a center portion of the pixel electrode 21 may be arranged on the pixel electrode 21. The pixel-defining layer 19 may include an organic insulating material and/or an inorganic insulating material. The opening 19OP may define an emission area EA of light emitted from the organic light-emitting diode OLED. For example, a width of the opening 19OP may correspond to a width of the emission area EA.

An emission layer 22 may be arranged at the opening 19OP of the pixel-defining layer 19. The emission layer 22 may include a high-molecular weight organic material or low-molecular weight organic material which emit a light of certain color. According to an embodiment, the emission layer 22 may include a quantum dot material. The emission layer 22 may be formed by discharging droplets onto an apparatus for manufacturing a display device according to an embodiment.

Although not illustrated, a first functional layer and a second functional layer may be disposed below and on the emission layer 22. The first functional layer may include, for example, a hole transport layer (HTL) or may include an HTL and a hole injection layer (HIL). The second functional layer may be a component disposed on the emission layer 22 and may be optional. The second functional layer may include an electron transport layer (ETL) and/or an electron injection layer (EIL). Like a common electrode 23 described below, the first functional layer and/or the second functional layer may be a common layer formed to entirely cover the substrate 100.

The common electrode 23 may include a conductive material with a low work function. For example, the common electrode 23 may include a (semi-)transparent layer including Ag, Mg, Al, Pt, Pd, Au, Ni, Nd, Ir, Cr, lithium (Li), calcium (Ca), an alloy thereof, or a combination thereof. For another example, the common electrode 23 may further include a layer including ITO, IZO, ZnO, In₂O₃, or a combination thereof, on the (semi-)transparent layer including such a material.

The capping layer CPL may be provided on the common electrode 23. The capping layer CPL may include a capping material. The capping layer CPL may include the first layer LY1, the second layer LY2, the third layer LY3, the fourth layer LY4, and the fifth layer LY5 described with reference to FIG. 11.

For example, the capping layer CPL may include LiF, an inorganic material, and/or an organic material. In detail, the capping layer CPL may include a carbocyclic compound, a heterocyclic compound, an amine group-containing compound, porphine derivatives, phthalocyanine derivatives, naphthalocyanine derivatives, an alkali metal complex, an alkaline earth metal complex, or any combination thereof. The carbocyclic compound, the heterocyclic compound, and the amine group-containing compound may be selectively substituted by a substituent including oxygen (O), nitrogen (N), sulfur (S), selenium (Se), silicon (Si), fluorine (F), chlorine (Cl), bromine (Br), iodine (I), or any combination thereof.

The thin-film encapsulation layer TFE may be disposed on the capping layer CPL. According to an embodiment, the thin-film encapsulation layer TFE may include at least one inorganic encapsulation layer and at least one organic encapsulation layer, and according to an embodiment, FIG. 13 shows that the thin-film encapsulation layer TFE may include a first inorganic encapsulation layer 31, an organic encapsulation layer 32, and a second inorganic encapsulation layer 33 which are sequentially stacked on each other.

The first inorganic encapsulation layer 31 and second inorganic encapsulation layer 33 may include one or more inorganic materials from among aluminum oxide, titanium oxide, tantalum oxide, hafnium oxide, zinc oxide, silicon oxide, silicon nitride, and silicon oxynitride. The organic encapsulation layer 32 may include a polymer-based material. Examples of the polymer-based material may include an acrylic resin, an epoxy resin, polyimide, polyethylene, or a combination thereof. According to an embodiment, the organic encapsulation layer 32 may include acrylate.

According to an embodiment, the thin-film encapsulation layer TFE may have a structure in which the substrate 100 and an upper substrate of a transparent member may be combined via a sealing member, thereby sealing an internal space between the substrate 100 and the upper substrate. Here, a moisture absorbent or filler may be located in the internal space. The sealing member may be a sealant, and according to an embodiment, the sealing member may include a material hardened by a laser beam. For example, the sealing member may be a frit. In detail, the sealing member may include a urethane-based resin, an epoxy-based resin, or an acryl-based resin, which is an organic sealant, or silicon that is an inorganic sealant. The urethane-based resin may use, for example, urethane acrylate. The acryl-based resin may use, for example, butyl acrylate or ethylhexylacrylate. The sealing member may include a material hardened by heat.

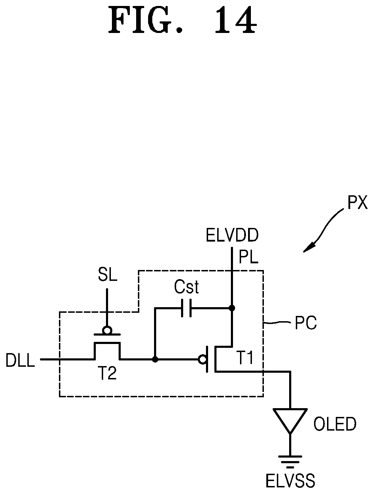

FIG. 14 is a schematic diagram of an equivalent circuit of a pixel PX in a display panel according to an embodiment.

Each pixel PX may include a pixel circuit PC and a display element. For example, the display element may include the organic light-emitting diode OLED that is electrically connected to the pixel circuit PC. The pixel circuit PC may include a first thin-film transistor T1, a second thin-film transistor T2, and the storage capacitor Cst. Each pixel PX may be configured to emit, for example, red, green, blue, or white light through the organic light-emitting diode OLED.

The second thin-film transistor T2 may be a switching thin-film transistor that is connected to a scan line SL and a data line DLL, and may be configured to transmit a data voltage input from the data line DLL to the first thin-film transistor T1 based on a switching voltage input from the scan line SL. The storage capacitor Cst may be connected to the second thin-film transistor T2 and a driving voltage line PL, and may store a voltage corresponding to a difference between a voltage received from the second thin-film transistor T2 and a first power voltage ELVDD supplied to the driving voltage line PL.

The first thin-film transistor T1 may be a driving thin-film transistor that is connected to the driving voltage line PL and the storage capacitor Cst, and may control a driving current flowing through the organic light-emitting diode OLED from the driving voltage line PL in response to a voltage value stored in the storage capacitor Cst. The organic light-emitting diode OLED may be configured to emit light of a certain luminance according to the driving current. An opposing electrode (for example, a cathode) of the organic light-emitting diode OLED may receive a second power voltage ELVSS.

In FIG. 14, the pixel circuit PC may include two thin-film transistors and a storage capacitor (e.g., single storage capacitor), but the invention is not limited thereto. The number of thin-film transistors and the number of storage capacitors may vary depending on a design of the pixel circuit PC. For example, the pixel circuit PC may further include four or more thin-film transistors, in addition to the two thin-film transistors described above.

According to embodiments, a structure of an apparatus for manufacturing a display device may be simplified and process efficiency may increase.

The effects of the invention are not limited to those mentioned above, and other effects that are not mentioned may be clearly understood by one of ordinary skill in the art from the scope of claims.

It should be understood that embodiments described herein should be considered in a descriptive sense only and not for purposes of limitation. Descriptions of features or aspects in each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An apparatus (1) for manufacturing a display device, the apparatus (1) comprising:
a chamber (10);
a support part (20) within the chamber (10) supporting a display substrate (DS);
a deposition source (50) arranged in the chamber (10) and including a first deposition part (51) adapted to eject a first deposition material (M1) towards the display substrate (DS) and a second deposition part (52) adapted to eject a second deposition material (M2) towards the display substrate (DS); and
a moving part (90) adapted to move the deposition source (50) in a first direction and a second direction opposite to the first direction relative to the display substrate (DS), wherein
the display substrate (DS) is arranged on a virtual plane (S1),
the virtual plane (S1) comprises:
a first area (ARE1) where the first deposition material (M1) reaches and spaced apart from the second deposition material (M2);
a second area (ARE2) where the first deposition material (M1) and the second deposition material (M2) each reach; and
a third area (ARE3) where the second deposition material (M2) reaches and spaced apart from the first deposition material (M1), and
the first area (ARE1), the second area (ARE2) and the third area (ARE3) are defined with respect to the deposition source (50) and move together with the deposition source (50) to different locations on the virtual plane (S1).

2. The apparatus (1) of claim 1, wherein the moving part (90) is adapted to move the deposition source (50) sequentially in the first direction and the second direction relative to the display substrate (DS) such that the display substrate (DS) sequentially passes through the first area (ARE1), the second area (ARE2), the third area (ARE3), the second area (ARE2), and the first area (ARE1).

3. The apparatus (1) of claim 1 or 2, adapted to
deposit a first layer (LY1) including the first deposition material (M1) on the display substrate (DS), when the display substrate (DS) passes through the first area (ARE1),
deposit a second layer (LY2) including the first deposition material (M1) and the second deposition material (M2) on the display substrate (DS), when the display substrate (DS) passes through the second area (ARE2),
deposit a third layer (LY3) including the second deposition material (M2) on the display substrate (DS), when the display substrate (DS) passes through the third area (ARE3),
deposit a fourth layer (LY4) including the first deposition material (M1) and the second deposition material (M2) on the display substrate (DS), when the display substrate (DS) passes through the second area (ARE2) again, and
deposit a fifth layer (LY5) including the first deposition material (M1) on the display substrate (DS), when the display substrate (DS) passes through the first area (ARE1) again.

4. An apparatus (1) for manufacturing a display device, the apparatus (1) comprising:
a chamber (10);
a support part (20) within the chamber (10) supporting a display substrate (DS);
a deposition source (50) arranged in the chamber (10) and including a first deposition part (51) adapted to eject a first deposition material (M1) towards a display substrate (DS) and a second deposition part (52) adapted to eject a second deposition material (M2) towards the display substrate (DS); and
a moving part (90) adapted to sequentially move the deposition source (50) in a first direction and a second direction opposite to the first direction relative to the display substrate (DS), wherein
a first layer (LY1) including the first deposition material (M1), a second layer (LY2) including the first deposition material (M1) and the second deposition material (M2), a third layer (LY3) including the second deposition material (M2), a fourth layer (LY4) including the first deposition material (M1) and the second deposition material (M2), and a fifth layer (LY5) including the first deposition material (M1) are sequentially deposited on the display substrate (DS), wherein
the display substrate (DS) is disposed in a virtual plane (S1) defined with respect to the deposition source (50).

5. The apparatus (1) of claim 4, wherein the virtual plane (S1) comprises:
a first area (ARE1) where the first deposition material (M1) reaches and spaced apart from the second deposition material (M2);
a second area (ARE2) where the first deposition material (M1) and the second deposition material (M2) each reach; and
a third area (ARE3) where the second deposition material (M2) reaches and spaced apart from the first deposition material (M1).

6. The apparatus (1) of claim 5, wherein the display substrate (DS) sequentially passes through the first area (ARE1), the second area (ARE2), the third area (ARE3), the second area (ARE2), and the first area (ARE1).

7. The apparatus (1) of at least one of claims 3 to 6, wherein, in the second layer (LY2), a concentration of the second deposition material (M2) gradually increases compared to the first deposition material (M1) in a direction towards the third layer (LY3).

8. The apparatus (1) of at least one of claims 3 to 7, wherein, in the fourth layer (LY4), a concentration of the first deposition material (M1) gradually increases compared to the second deposition material (M2) in a direction towards the fifth layer (LY5).

9. The apparatus (1) of at least one of claims 3 to 8, wherein each of the first deposition material (M1) and the second deposition material (M2) comprises a capping material.

10. The apparatus (1) of at least one of claims 3 to 9, wherein a refractive index of the third layer (LY3) is greater than a refractive index of each of the first layer (LY1) and the fifth layer (LY5).

11. The apparatus (1) of at least one of claims 3 to 10, wherein a thickness of the fifth layer (LY5) is greater than a thickness of the first layer (LY1).

12. The apparatus (1) of at least one of claims 1 to 11, wherein the first deposition part (51) comprises a first-1 deposition part (51-1) and a first-2 deposition part (51-2) which eject a same material.

13. The apparatus (1) of claim 12, wherein the first-1 deposition part (51-1), the first-2 deposition part (51-2), and the second deposition part (52) are sequentially arranged in a linear manner.

14. A method of manufacturing a display device with an apparatus (1) according to at least one of claims 1 to 13, comprising the steps of:
supporting a display substrate (DS) with the support part within the chamber (10) of the apparatus (1);
ejecting with the first deposition part (51) of the deposition source (50) the first deposition material (M1) towards the display substrate (DS);
ejecting with the second deposition part (52) of the deposition source (50) the second deposition material (M2) towards the display substrate (DS); and
moving with the moving part (90) the deposition source (50) in the first direction and the second direction opposite to the first direction relative to the display substrate (DS), wherein
the display substrate (DS) is arranged on a virtual plane (S1), the virtual plane (S1) includes the first area (ARE1) where the first deposition material (M1) reaches and which is spaced apart from the second deposition material (M2), the second area (ARE2) where the first deposition material (M1) and the second deposition material (M2) each reach, and the third area (ARE3) where the second deposition material (M2) reaches and which is spaced apart from the first deposition material (M1), and the first area (ARE1), the second area (ARE2), and the third area (ARE3) are defined with respect to the deposition source (50) and move together with the deposition source (50) to different locations on the virtual plane (S1).
